# EUROPEAN PATENT APPLICATION

(11) **EP 2 651 198 A2**
(43) Date of publication of application: **16.10.2013**
(21) Application number: 12186000.1
(22) Date of filing: 26.09.2012
(51) Int. Cl.: H05K 1/02, H05K 1/03

(54) **Plasticized ceramic thermal dissapation module**

(30) Priority: 12.04.2012 TW 101206704 U
(71) Applicant: Ni, Chin Huan, Taoyuan County 32456 (TW)
(72) Inventor: Ni, Chin Huan, Taoyuan County 32456 (TW)
(74) Representative: Bucher, Ralf Christian

(57) **Abstract**

A plasticized ceramic thermal dissipation module comprises a heating electrical component (1), a cooling body (2), and a thermal conductive device (3). They are located orderly. The thermal conductive device is a substrate (e.g. a high thermal conductive circuit board or a LED module board) and the heating electrical component is arranged on the substrate, in which the cooling body is a plasticized ceramic and seamlessly integrated with the thermal conductive device together as a component (All-In-One). The present invention efficiently integrates electrical circuits (or package) board with cooling body together, may be able to simplify the assembling process during the late production stage, to decrease the thermal resistance between the two components during assembling and efficiently enhances the thermal conductive performance, furthermore, the plasticized ceramic with high thermal conductive coefficient has excellent lateral thermal conductive ability to enhance the cooling performance, and be able to integrate with different types of circuits (or package) boards together to increase product's productivity and design flexibility.

## Description

### FIELD OF THE INVENTION

The present invention relates to a thermal dissipation apparatus, especially for a new type of plasticized ceramic thermal dissipation module.

### BACKGROUND OF THE INVENTION

Traditional circuits (or package) boards in current market generally use ceramic circuits (or package) boards or PCB circuits (or package) boards with corresponding heat sink devices, in which the heat sink devices usually are ceramic heat sinks, metal heat sinks, plastic heat sinks, and composite materials heat sinks; currently the thermal dissipation modules of circuits (or package) boards are usually connected with circuits (or package) boards by soldering, gluing, or using fasteners, screws, or corresponding thermal grease. The surfaces of these two components cannot completely match and the space or air between these two surfaces will seriously impact the heat sink performance of thermal dissipation modules; no matter using soldering, gluing, or fasteners, screws with corresponding thermal grease to combine circuits board and thermal dissipation module, there is a medium existed between these two components and this medium will increase the thermal resistance of this whole thermal dissipation module and destroy the thermal conductive performance and heat sink performance; furthermore, this thermal dissipation module needs to be assembled during production line that increases the production cost.

Therefore, how to improve above disadvantages of traditional technology is the main topic of the present invention.

### SUMMARY OF THE INVENTION

The objective of the present invention is to provide a thermal dissipation module that is able to integrate circuits (or package) board with heat sink efficiently, to simplify the assembling process during the late production stage, to decrease the thermal resister between the two components during assembling and efficiently enhances the thermal dissipation performance.

Accordingly, the present invention provides a new and advanced thermal dissipation module, which comprises the following components: a heating electrical component, a cooling body, and a thermal conductive device, and these three components are integrated together orderly, in which the cooling body is made by plasticized ceramic and seamlessly integrates or All-In-One with above thermal conductive device together as a single piece.

In accordance with the plasticized ceramic thermal dissipation module, because plasticized ceramic is for thermal conducting and heat dissipation, the cooling body and thermal conductive device in the present invention are both made by plasticized ceramic.

In accordance with the plasticized ceramic thermal dissipation module, the plasticized ceramic is made by SiC or other high thermal conductive ceramic materials with low thermal conductive engineering plastic materials to achieve the expected heat conduction and dissipation performance.

In accordance with the plasticized ceramic thermal dissipation module, the thermal conductive device in the present invention is a substrate, on which we may place circuits and accommodate the heating electrical component.

Furthermore, in accordance with the plasticized ceramic thermal dissipation module, the substrate is a high thermal conductive circuit board or a well-packaged LED module board.

In accordance with the plasticized ceramic thermal dissipation module, there is a cavity designed in the cooling body in the present invention, and the cavity structure is able to decrease the weight of this thermal dissipation module;

In accordance with the plasticized ceramic thermal dissipation module, in order to enhance the heat dissipation performance, there is a second thermal conductive device designed in the cavity.

In accordance with the plasticized ceramic thermal dissipation module, in order to optimize the thermal conductive performance and heat dissipation performance of this thermal dissipation module in the present invention, the module integrates the plasticized ceramic and the thermal conductive ceramic with multiple porosities.

The present invention relates to a plasticized ceramic thermal dissipation module, which integrates efficiently circuits (or package) board with cooling body to simplify the assembling process during the late production stage, to decrease the thermal resistance between the two components during assembling and efficiently enhances the thermal conductive and heat dissipation performance. The plasticized ceramic with high thermal conductive coefficient (even) has excellent lateral thermal conductive ability to enhance the heat dissipation performance of cooling body, and be able to integrate with different types of circuits (or package) boards together to increase product's productivity and design flexibility.

The present invention may best be understood through the following description with reference to the accompanying drawings, in which:

### BRIEF DESCRIPTION OF THE DRAWINGS

Fig.1 shows the schematic diagram of the executive embodiment 1 to the present invention of plasticized ceramic thermal dissipation module;
Fig.2 shows another schematic diagram of the executive embodiment 1 to the present invention of plasticized ceramic thermal dissipation module;
Fig.3 shows the schematic diagram of the executive embodiment 2 to the present invention of plasticized ceramic thermal dissipation module;
Fig.4 shows another schematic diagram of the executive embodiment 2 to the present invention of plasticized ceramic thermal dissipation module;
Fig.5 shows the schematic diagram of the executive embodiment 3 to the present invention of plasticized ceramic thermal dissipation module;
Fig.6 shows the schematic diagram of the executive embodiment 4 to the present invention of plasticized ceramic thermal dissipation module;
Fig.7 shows the schematic diagram of the executive embodiment 5 to the present invention of plasticized ceramic thermal dissipation module;
Fig. 8 shows another schematic diagram of the executive embodiment 5 to the present invention of plasticized ceramic thermal dissipation module;
Fig.9 shows the schematic diagram of the executive embodiment 6 to the present invention of plasticized ceramic thermal dissipation module;
Fig.10 shows another schematic diagram of the executive embodiment 6 to the present invention of plasticized ceramic thermal dissipation module;
Fig.11 shows the schematic diagram of the executive embodiment 7 to the present invention of plasticized ceramic thermal dissipation module.

### DETAILED DESCRIPTION OF THE PREFERRED EMBODIMENT

### Executive embodiment 1

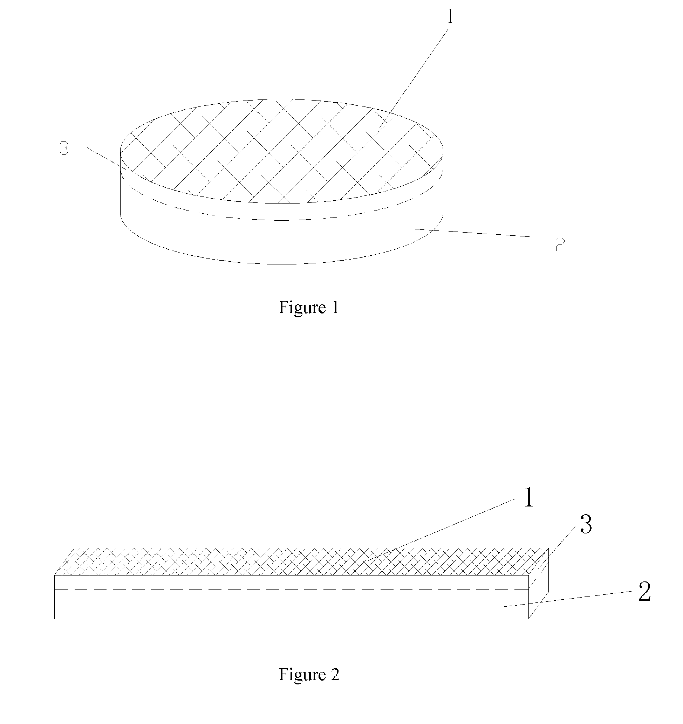

Fig. 1 and Fig. 2 show the schematic diagrams of the executive embodiment to the present invention of plasticized ceramic thermal dissipation module, in which comprises a heating electrical component 1, a cooling body 2, and a higher thermal conductive device 3, and these three elements are integrated together orderly; in which the thermal conductive device 3 is a high thermal conductive circuit board, the cooling body 2 is made by plasticized ceramic and seamlessly integrated or All-In-One with thermal conductive device 3 together as a single element, to simplify the assembling process during the late production stage, to decrease the thermal resistance between the two components during assembling and efficiently enhances the thermal conductive and heat dissipation performance.

### Executive embodiment 2

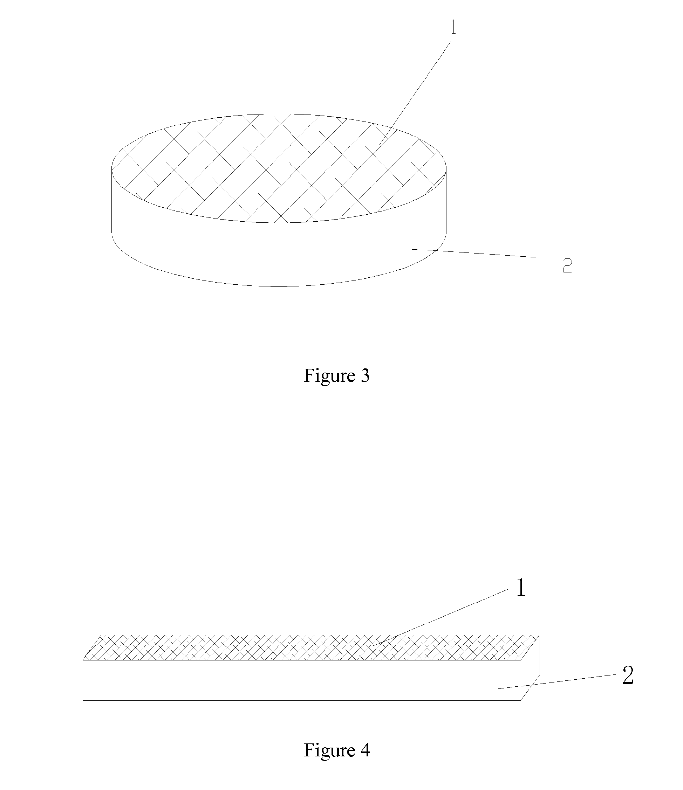

Fig. 3 and Fig. 4 show other schematic diagrams of the executive embodiment to the present invention of plasticized ceramic thermal dissipation module, in which comprises a heating electrical component 1 and a cooling body 2. Because plasticized ceramic has both excellent thermal conductive ability and heat dissipation ability, the cooling body 2, which may be as a thermal conductive device, is made in plasticized ceramic as a single component, the heating electrical component 1 located on the cooling body 2 can make thermal dissipation immediate.

### Executive embodiment 3

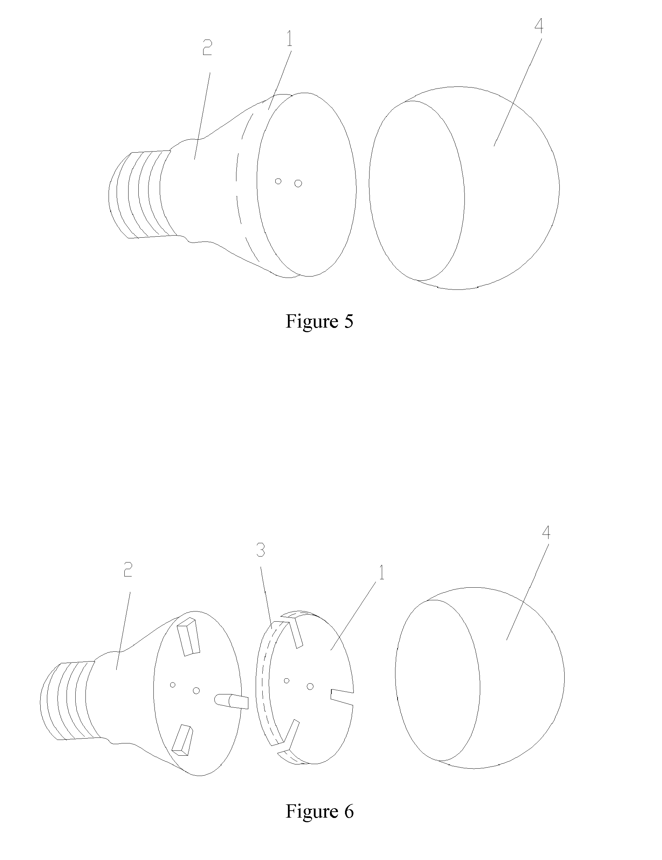

Fig. 5 shows other schematic diagrams of the executive embodiment to the present invention of plasticized ceramic thermal dissipation module, in which comprises a heating electrical component 1 and a cooling body 2 which may be as a thermal conductive device. They are integrated together sequentially; in which the cooling body 1, which may be as a thermal conductive device, is made in plasticized ceramic and integrated as a single component, and the heating electrical component 1 is located on the single component.

### Executive embodiment 4

Fig. 6 shows other schematic diagrams of the executive embodiment to the present invention of plasticized ceramic thermal dissipation module, in which comprises a heating electrical component 1, a cooling body 2, and a thermal conductive device 3, these three components are integrated together sequentially; in which the thermal conductive device 3 is an LED module board and the heating electrical component 1, which may be a LED lamp, is designed on this board, in order to integrate the cooling body 2 with the LED module board very efficiently and to well control the coefficient of thermal expansion, in which the cooling body 2 is made by plasticized ceramic and integrates with thermal conductive device 3 seamlessly as a single component, and then combined with a protecting case 4 to be assembled as a LED thermal dissipation module; in which the matching between cooling body 2 and thermal conductive device 3 is accurately controlled by many parameters and processed through heated, cooled, injection pressure, injection speed, injection dosage, pressure maintaining, and gas exhausting, etc., to make the pre-arranged LED module board and plasticized ceramic can be integrated as a body during the injection modeling processes, and this thermal dissipation module can solve the thermal over problem of LED.

### Executive embodiment 5

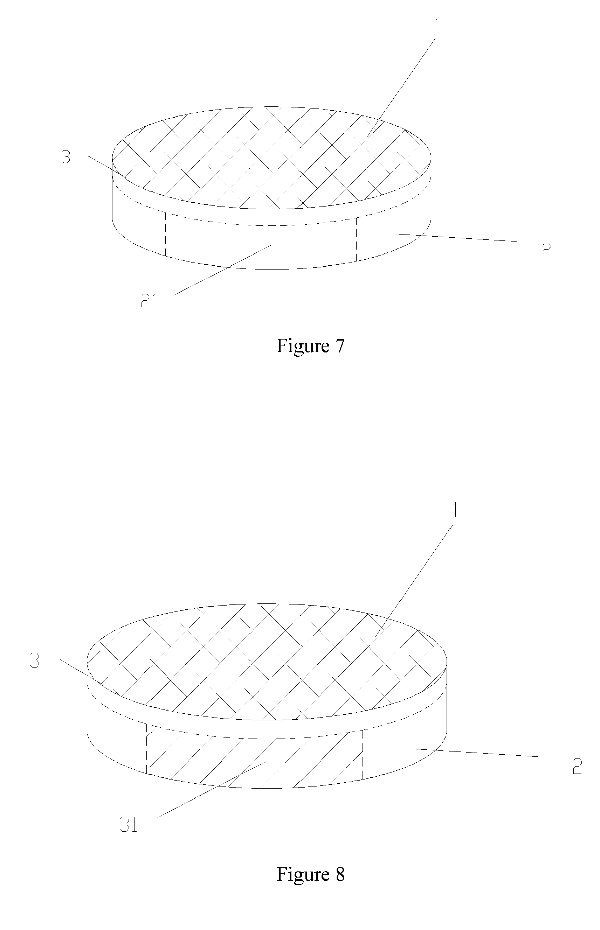

Fig. 7 shows other schematic diagrams of the executive embodiment to the present invention of plasticized ceramic thermal dissipation module, in which comprises a heating electrical component 1, a cooling body 2, and a thermal conductive device 3, these three components are integrated together sequentially; in which the thermal conductive device 3 is a high thermal conductive circuit board and the heating electrical component 1 designed on this board, the cooling body 2 is made by plasticized ceramic and integrates with the thermal conductive device 3 seamlessly as a single component. In order to decrease the weight of thermal dissipation module, there is a cavity 21 vertically designed inside the cooling body 2 and the cavity 21 is able to enhance the heat dissipation performance of the cooling body 2 very efficiently.

Furthermore, due to plasticized ceramic has excellent lateral thermal conductive ability, in order to enhance the vertical thermal conductive ability, a cavity designed in the cooling body 2 as shown in Fig. 8, and there is a second thermal conductive device 31 designed in the cavity 21, which makes the heat flow be able to spread both laterally and vertically.

### Executive embodiment 6

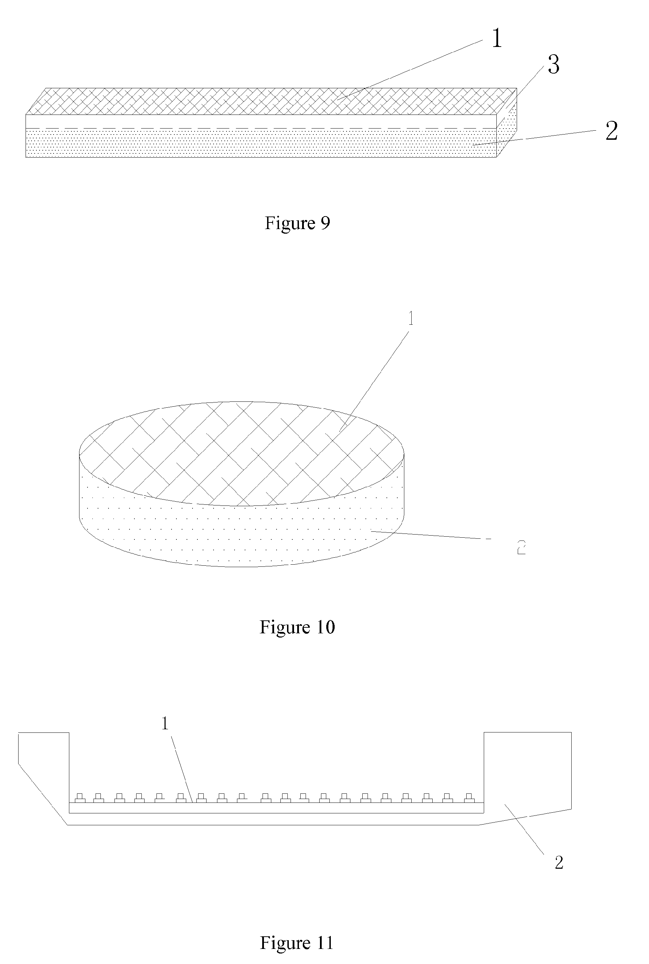

Fig. 9 and Fig. 10 show other schematic diagrams of the executive embodiment to the present invention of plasticized ceramic thermal dissipation module, in which comprises a heating electrical component 1, a cooling body 2, and a thermal conductive device 3, these three components are integrated together sequentially; in which the thermal conductive device 3 is a ceramic circuits board with high thermal conductive and multiple porosities, and there is a heating electrical component 1 designed on this board, cooling body 2 is made by plasticized ceramic and integrates with thermal conductive device 3 seamlessly as a single component, to be able to enhance the heat dissipation performance of the cooling body 2 very efficiently.

### Executive embodiment 7

Fig. 11 shows other schematic diagrams of the executive embodiment to the present invention of plasticized ceramic thermal dissipation module, in which comprises a heating electrical component 1, a cooling body 2, and a thermal conductive device. The cooling body 2 and thermal conductive device forms a LCD TV chassis that are made by plasticized ceramic.

For increasing the life time of LCD TV and saving cost of thermal dissipation module,

The heating electrical component 1 is electrical conductive circuits and LED on the cooling body 2 by using plasticized ceramic module's excellent thermal conductive ability and heat dissipation ability to approach good heat dissipation performance.

Since various modifications can be made in the invention as hereinabove described, and many apparently widely different embodiments of same made within the spirit and scope of the claims without departing from such spirit and scope, it is intended that all matter contained in the accompanying specification shall be interpreted as illustrative only and not in a limiting sense.

## Claims

1. A plasticized ceramic thermal dissipation module comprising a heating electrical component, a cooling body, and a thermal conductive device, the cooling body, thermal conductive device, and heating electrical component being integrated together sequentially; the cooling body being made by plasticized ceramic and integrated with the thermal conductive device seamlessly as a single component.

2. The plasticized ceramic thermal dissipation module according to claim 1, wherein the cooling body and the thermal conductive device is both made by plasticized ceramic.

3. The plasticized ceramic thermal dissipation module according to claim 1, wherein the cooling body is a substrate and the heating electrical component designed on the substrate.

4. The plasticized ceramic thermal dissipation module according to claim 3, wherein the substrate is a high thermal conductive circuits board.

5. The plasticized ceramic thermal dissipation module according to claim 3, wherein the substrate is a LED module board.

6. The plasticized ceramic thermal dissipation module according to claim 2, 4 or 5, wherein the cooling body comprises a cavity.

7. The plasticized ceramic thermal dissipation module according to claim 6, wherein a second thermal conductive device designed in the cavity.

8. The plasticized ceramic thermal dissipation module according to claim 7, wherein the second thermal conductive device is made by ceramic with multiple porosities.
